(19)

Europäisches Patentamt
European Patent Office
Office européen des brevets

(11) **EP 1 770 842 A1**

(12) **EUROPEAN PATENT APPLICATION**

(43) Date of publication:
**04.04.2007 Bulletin 2007/14**

(51) Int Cl.:
*H02H 5/04* (2006.01)

(21) Application number: **05405563.7**

(22) Date of filing: **29.09.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **ABB Research Ltd**
**8050 Zürich (CH)**

(72) Inventors:
• **Deck, Bernhard**
**79809 Weilheim (DE)**

• **Kramer, Beat**
**5210 Windisch (CH)**
• **Sabbattini, Bruno**
**8006 Zürich (CH)**
• **Brändle, Hubert**
**8102 Oberengstringen (CH)**

(74) Representative: **ABB Patent Attorneys**
**c/o ABB Schweiz AG,**
**Intellectual Property (CH-LC/IP),**
**Brown Boveri Strasse 6**
**5400 Baden (CH)**

(54) **Apparatus for the detection of an overcurrent in a conductor and method for operating such an apparatus**

(57) An apparatus for the detection of an overcurrent in an electrical conductor (1) comprises a first temperature sensor (2), which is galvanically separated from the conductor (1). The first temperature sensor (2) is arranged close to the conductor (1) and aligned towards the conductor (1) to directly measure the temperature or temperature change induced in the conductor (1). The apparatus further comprises an allocation unit (3) for allocating the measured temperature or temperature change in the conductor (1) to the overcurrent.

FIG. 1

EP 1 770 842 A1

## Description

Field of the Invention

The invention relates to the field of power electronics and more particularly to an apparatus for the detection of an overcurrent in a conductor and to a method for operating such an apparatus according to the preamble of the independent claims.

Background of the Invention

In the document US 4,054,934 an overcurrent relay is described. A current transformer is provided on a power line. The current transformer is electrically connected to a slender wire, usually in the form of a filament of a lamp. Radiation emitted by the lamp is detected by an infrared detector, which is connected to a gate circuit of a silicon controlled rectifier. This rectifier is connected in series to a DC power source and a trip coil, which is again connected to a circuit breaker. Under normal condition the tripping circuit is open. When an overcurrent occurs on the power line, the primary current rises, which leads to a rise of the secondary current at the lamp, which rise is proportional to the variation in the primary current. The lamp produces heat, which energizes the infrared detector. Thus current is provided, which triggers the rectifier, thereby closing the tripping circuit. Thereby the DC power source feeds the trip coil, which opens the circuit breaker.

The infrared detector in such an prior art overcurrent relay is used to initialize the opening of a circuit breaker, if a predetermined radiation signal is exceeded. Therefore, the infrared sensor is not used as detection means to estimate the amount of overcurrent, but only to react at a predetermined value. Current transformers are expensive, heavy and unwieldy in use. The relay can merely be used as a reactive means in case of an existing overcurrent, not for preventive means. It is not possible to measure the primary current directly on the power line, but the current first has to be transformed into secondary current and then converted in the slender wire to heat radiation. Therefore, there is a certain probability of faults or defects in the measuring chain.

Description of the Invention

It is an object of the invention to provide an apparatus for the detection of an overcurrent in a conductor, which is lightweight, compact, inexpensive and easy to use and to provide a method for operating such an apparatus.

This object is achieved by an apparatus and a method according to the independent claims.

An apparatus for the detection of an overcurrent in a conductor according to the invention comprises a first temperature sensor, which is galvanically separated from the conductor. The first temperature sensor is aligned towards the conductor to directly measure the temperature or temperature change induced in the conductor. The apparatus further comprises an allocation unit for allocating the measured temperature or temperature change of the conductor to the overcurrent induced in the conductor by an overcurrent. The inventive apparatus comprises inexpensive, lightweight and easy to handle components. The apparatus is easy to use, because only a temperature or temperature change has to be measured, avoiding the need of using heavy current transformers and the apparatus works reliable, because the temperature or temperature induced in the conductor by a primary current is measured without the need of intermediate steps.

In a first preferred embodiment the first temperature sensor is an infrared sensor, in particular a pyroelectrical sensor or a thermopile sensor. As pyroelectrical sensors are commonly used as burglar detectors and thermopile sensors as clinical thermometers, these sensors are widespread and inexpensive.

In another preferred embodiment the conductor comprises means for enhancing the thermal radiation emitted by the conductor towards the sensor. Such means can be a conductor region with decreased cross-section, in particular a recess in the conductor, to which region the first temperature sensor is aligned. Such a recess has the advantage that the cross-section of the conductor is reduced in that conductor region, the reduced cross-section leading to a higher heating in said conductor region. The first temperature sensor can be positioned within the recess, therefore enhancing the amount of thermal radiation towards the temperature sensor, because the heat producing conductor region surrounds the first temperature sensor and thereby, the heat is emitted towards the first temperature sensor from a great solid angle. In another preferred embodiment the recess is a hole with a depth, which is about twice the diameter of the hole. Such a hole has a high emission, because the hole appears as a black radiator for infrared radiation. The emission from such a hole does not decrease due to aging effects. Other means can be a conductor region with a treated surface, in particular with a modified surface finish or a modified surface colouring, and the first temperature sensor is aligned towards this conductor region. Such treated surfaces can be a reduced unevenness of the surface or colouring of the surface with a dark colour. Further means can be a convex shaped infrared lens, which is arranged between the first temperature sensor and the conductor and with which lens more thermal radiation can be collected or the distance between the sensor and the conductor can be enlarged, thereby improving the electrical insulation between the conductor and the first temperature sensor. Another means are a conductor region with a conductive heating element, which conductive heating element has an enhanced specific resistance compared to the adjoining conductor regions. The first temperature sensor is aligned towards this conductor region with the conductive heating element having an enhanced specific resistance, by which the heating element is heated more than the adjoining conductor regions, thereby enhancing the thermal radiation emitted from the conductor. A combination of any of the means is possible and further enhances the thermal radiation towards the sensor.

In a further preferred embodiment of the inventive apparatus a heat insulation surrounds the conductor and / or the first temperature sensor. This has the effect that the apparatus is less sensible to ambient temperature changes and to unintentional losses of thermal radiation emitted from the conductor.

The method for operating an apparatus for the detection of an overcurrent in an electrical conductor according to the invention comprises the following steps:

- a first temperature sensor, in particular an infrared sensor, which is galvanically separated from an electrical conductor, is aligned towards the conductor,
- a temperature or temperature change induced in the conductor is directly measured with the first temperature sensor, and
- the measured temperature or temperature change is allocated in an allocation unit to the overcurrent.

This method is very easy to carry out. The method is straightforward, because the temperature or temperature change, which can be unambiguously allocated to a primary current, is directly measured on the conductor, not needing current transformations to a secondary current. Furthermore, temperature sensors are typically very small and light and easy to operate. A laser pointer, fixed to the first temperature sensor, can be used to calibrate the temperature sensor in distance to the measured object before mounting and to align the first temperature sensor to the same direction as the laser pointer, thereby showing at least a point within the area, from which the temperature can be measured with the first temperature sensor.

In a further preferred embodiment, the allocation unit comprises means for the calculation of the overcurrent from the measured temperature or temperature change according to

$$I = \sqrt{\frac{\Delta T}{\Delta t} \frac{A^2 \gamma c}{\rho}}$$

with I being the calculated overcurrent, $\Delta T$ being a measured temperature change, $\Delta t$ being a time period, over which the temperature change is measured, A being a cross-section, $\gamma$ being a density, c being a specific heat capacity and $\rho$ being a specific resistance of the conductor. Such calculation means give overcurrent values according to the actual measured temperature or temperature change.

A second temperature sensor can be used to measure the ambient temperature, which temperature can be used for calibration or correction purposes. As thermal radiation increases with about an exponent of four with temperature the sensitivity of the sensor varies with the measured temperature. Without compensating this effect a sensor at low temperature would result in too low values compared to a sensor at a higher temperature. The ambient temperature can also be used for regular resets or for taking the temperature dependency of the specific resistance of the conductor into account.

In another preferred embodiment a signal is generated when a limit value is reached. Such limit values can be a maximum allowed overcurrent, a maximum allowed overcurrent over a defined time period and / or a maximum allowed overcurrent change. This signal can be sent via cable or cableless for example to a circuit breaker, to a relay, to a switch or to a control station. It can effect a voltage cutoff of the conductor by the circuit breaker or switch.

in a further embodiment a prospective remaining time is estimated until a limit value, in particular a maximum allowed overcurrent and / or a maximum allowed overcurrent over a defined time period, will be reached. This gives the possibility to start preventive actions before a short circuit arises.

Further advantages according to the present invention will be apparent from the dependent claims.

Brief Description of the Drawings

The subject matter of the invention will be explained in more detail in the following text with reference to the attached drawings, in which:

FIG. 1    shows a first embodiment of the apparatus according to the invention; and

FIG. 2    shows a further embodiment of the apparatus according to the invention with a conductive heating element;

FIG. 3    shows a further embodiment of the apparatus according to the invention with a conductive heating element and a recess; and

FIG. 4    shows a further embodiment of the apparatus according to the invention with a heat insulation and a second temperature sensor.

Generally, alike or alike-functioning parts are given the same reference symbols. The described embodiments are meant as examples and shall not confine the invention.

Detailed Description of Preferred Embodiments

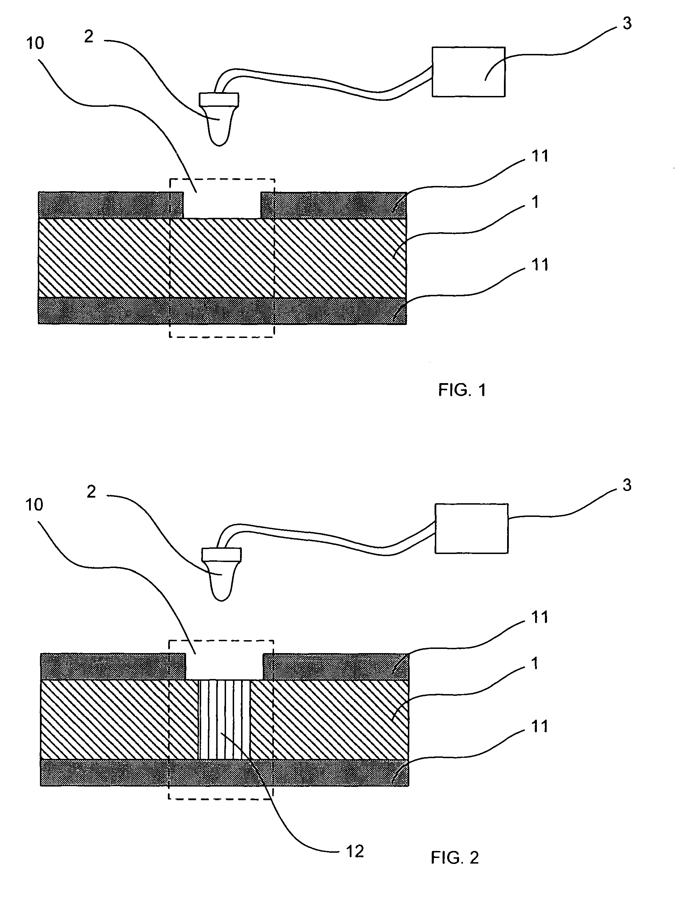

FIG. 1 shows an apparatus for the detection of an overcurrent in an electrical conductor 1 in accordance to the invention. The apparatus comprises a first temperature sensor 2, which is arranged close to the conductor and is aligned towards the conductor 1 to directly measure a temperature change in the conductor. The conductor 1 can be a cable or a rigid conductor with or without an electrical insulation. The first temperature sensor 2 is sensitive to thermal radiation or to conduction. In a preferred embodiment the first temperature sensor 2 is an infrared sensor, preferably a thermopile sensor or a pyroelectric sensor. Thermopile sensors are commonly known as clinical thermometers and dual pyroelectric sensors are known as burglar sensors. In FIG. 1 the conductor 1 is surrounded by an electrical insulation 11. In a conductor region 10, in which the temperature change induced in the conductor 1 by an overcurrent is to be measured, the electrical insulation is missing in order to measure the temperature change without a time delay. The first temperature sensor 2 is connected to an allocation unit 3, in which the measured temperature change in the conductor 1 is allocated to the overcurrent. The first temperature sensor 2 can be arranged in some distance to the conductor 1 (up to several ten centimeters) in order to achieve a good electrical insulation between the conductor 1 and the first temperature sensor 2 or in case that it is mechanically difficult to position the first temperature sensor 2 close to the conductor 1.

In another preferred embodiment the apparatus comprises means for enhancing the thermal radiation emitted from the conductor 1 towards the first temperature sensor 2. FIG. 2 shows an inventive apparatus with such means. The means comprise a conductor region 10 with a conductive heating element 12. The first temperature sensor 2 is aligned towards the heating element 12. The heating element 12 has an enhanced specific resistance compared to the specific resistance of adjacent conductor regions, so that in case of an overcurrent flowing through the heating element 12, the heating element 12 is more heated up than the neighboring parts of the conductor 1.

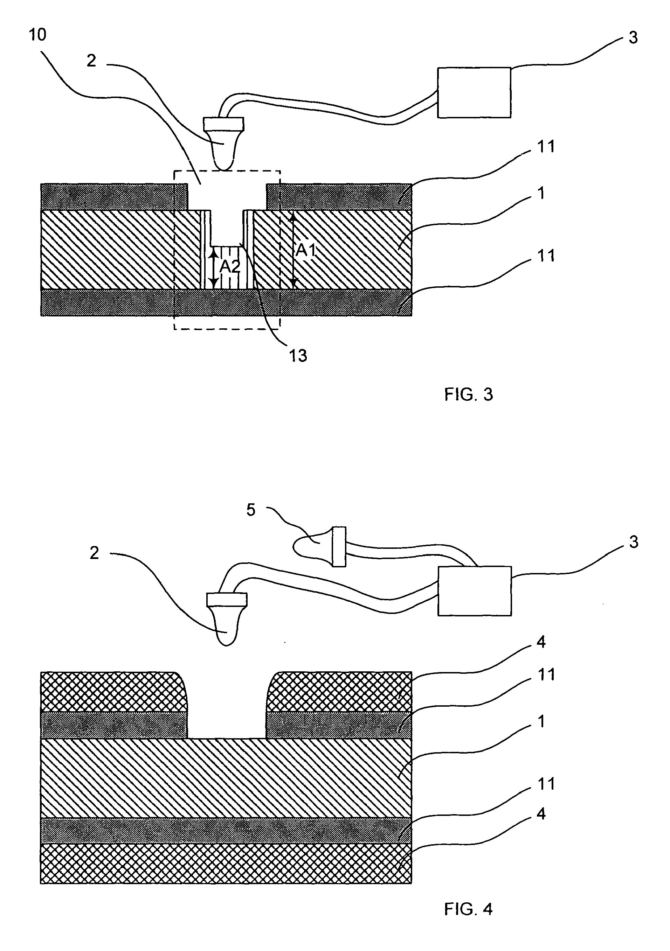

FIG. 3 shows an inventive apparatus with other means for enhancing the thermal radiation emitted from the conductor 1 towards the first temperature sensor 2. The conductor 1 has a first cross-section A1. The means comprise a conductor region 10 with a decreased second cross-section A2. In the conductor region 10 with decreased second cross-section A2 an enhanced amount of heat is produced compared to the heat produced in the adjoining conductor regions, resulting in a higher temperature change. In FIG. 3 the decreased second cross-section A2 is shown in the form of a recess 13 in the conductor region 10, but other forms of a decreased cross-sections like a notch surrounding the conductor 1 is also possible. The recess 13 can be designed in such a way, that the first temperature sensor 2 can be arranged within the recess 13, so that thermal radiation is emitted towards the first temperature sensor 2 from a great solid angle range, but electrical insulation between the conductor 1 and the first temperature sensor 2 has to be ensured.

Not shown in a figure is another means for enhancing the thermal radiation emitted from the conductor 1 towards the first temperature sensor 2 comprising a conductor region 10 with a treated surface. The first temperature sensor 2 is aligned towards this conductor region 10. Treating of the surface can be a modified surface structure like a shining or smooth surface, preferably by polishing, or a structure, which enhances the surface area. It is also possible that the conductor region 10 has a modified surface colouring like a black colouring, which can be produced by applying a lacquer layer or by evaporating a soot layer or by other chemical or physical processes.

Of course it is possible to combine any of the means for enhancing the thermal radiation emitted from the conductor 1 towards the first temperature sensor 2. For example, if the conductor region 10, to which the first temperature sensor 2 is aligned, comprises a recess 13 with blackened surface, and the first temperature sensor 2 is arranged in this recess 13, the emission of radiation is approximately that of a black body.

Also not shown in a figure is another means for enhancing the thermal radiation emitted from the conductor 1 towards the first temperature sensor 2 comprising a convex shaped infrared lens arranged between the first temperature sensor 2 and the conductor 1.

The specific resistance of the conductor 1 changes with temperature. The specific resistance can be described as a specific resistance given at a defined temperature and a portion given as the product of a thermal coefficient of the specific resistance at the actual temperature and the specific resistance at the defined temperature. Preferably, this temperature coefficient is small compared to the total specific resistance and linear in the temperature range of interest.

FIG. 4 shows a further preferred embodiment of the inventive apparatus. The conductor 1 and the first temperature sensor 2 are surrounded by heat insulation 4.

The heat insulation may have additionally electrically insulating properties. It is sufficient to have the heat insulation 4 solely surrounding the conductor region 10, to which first temperature sensor 2 is aligned.

In a further preferred embodiment the apparatus comprises a power supply, which may be either capacitively coupled to the conductor 1 by the electric field of the conductor or inductively coupled to the conductor 1 by its magnetic field for the purpose of power feeding the apparatus. Such a power supply works only in case of an overcurrent flowing through the conductor 1, but in case of no overcurrent, there is no heating to be measured.

In another preferred embodiment of the inventive apparatus the apparatus comprises a laser pointer, which can be fixed to the first temperature sensor or stuck together with it. The laser pointer points to the same direction as the first temperature sensor 2, so that the laser pointer can be used for the purpose of detection of correct mounting of the first temperature sensor 2 prior to a measurement.

The method for operating an apparatus for the detection of an overcurrent in an electrical conductor 1 is performed by carrying out the following steps:

- a first temperature sensor 2, in particular an infrared sensor, which is galvanically separated from an electrical conductor 1, is aligned towards the conductor 1,

- a temperature change induced in the conductor 1 is directly measured with the first temperature sensor 2, and

- the measured temperature change is allocated in an allocation unit 3 to the overcurrent.

The allocation of the measured temperature change to the overcurrent can be done by calculation or by comparison with measurements. In the case of comparison with measurements the temperature change in the conductor 1 is measured for different overcurrents. These values can be stored in a table and used for comparison to actual measured temperature changes.

The calculation of the overcurrent from the temperature change is deduced as follows.

The change of quantity of heat $\Delta Q$ induced in the conductor 1 by the overcurrent, measured in [J], is the product of the heat capacity C of the conductor 1, measured in [J/kg], and the temperature change $\Delta T$ induced in the conductor 1 by the overcurrent, measured in [K].

$$\Delta Q = C \Delta T$$

For an electrical conductor 1 the change of quantity of heat $\Delta Q$ can be also expressed as:

$$\Delta Q = I^2 R \Delta t$$

with I being an overcurrent, measured in [A], R being a resistance, measured in [$\Omega$] and $\Delta t$ being a time interval in [s].

The heat capacity C can be expressed as

$$C = cm$$

with c being the specific heat capacity, measured in [J/(kgK)] and m being a mass in [kg].

In a conductor the resistance R is the quotient of

$$R = \frac{\rho l}{A}$$

with $\rho$ being the specific resistance of the conductor 1, measured in [$\Omega$m], l being the length of the conductor 1, measured in [m] and A being the cross-section of the conductor 1, measured in [m$^2$].

With the density $\gamma = \dfrac{m}{Al}$, measured in [kg/m$^3$], the two equations for the quantity of heat $\Delta Q$ can be equated and resolved to

$$I = \sqrt{\frac{\Delta T}{\Delta t} \frac{A^2 c \gamma}{\rho}}$$

With this equation it is possible to calculate an overcurrent from a measured temperature change induced in the conductor 1 by the overcurrent.

FIG. 4 also shows a second temperature sensor 5, which is used to measure the ambient temperature. The ambient temperature can be used as a calibration value for the first temperature sensor 2 or as a reference value in order to distinguish between a temperature rise in the conductor due to a flow of an overcurrent or due to a rise of the ambient temperature, e.g. due to sunshine or due to other electrical components, which produce heat. Changes in ambient temperature typically lead to slow temperature changes in the conductor compared to temperature changes due to an overcurrent, and thereby it is possible to distinguish between a temperature change in the conductor 1 due to temperature changes in the environment of the conductor 1 or a temperature change induced by an overcurrent in the conductor 1.

The ambient temperature can also be used for taking the temperature dependency of the specific resistance of the conductor into account.

In another preferred embodiment a signal is generated, if a limit value is reached. Such a limit value can be a maximum allowed overcurrent, a maximum allowed overcurrent over a defined time period and / or a maximum allowed overcurrent change. The signal can e.g. activate a circuit breaker or a switch.

The method can also be used for preventive purposes by estimating from the calculated overcurrent a prospective remaining time until a limit value, in particular a maximum allowed overcurrent and / or a maximum allowed overcurrent over a defined time period, will be reached. This information could be sent to a control station to activate preventive steps before a short circuit happens.

Instead of measuring a temperature change in the conductor 1 with the first temperature sensor 2 the temperature in the conductor 1 can be measured in time intervals and from the emasured absolute temperature the temperature change is estimated.

The inventive apparatus can be applied to the primary electrical apparatus of a primary or secondary substation for the detection of a fault in a conductor 1. In such an electrical apparatus overcurrents up to 50 kA can occur at high voltages of several hundred kV down to medium voltage of some kV. The first temperature sensor 2 can measure the temperature change in the conductor 1, allocate an overcurrent to the temperature change and send this information to a relay to activate a switch or a circuit breaker if necessary.

Besides the possibility, that the method is performed continuously during operation of a device comprising at least one electrical conductor 1, the inventive apparatus can further be applied occasionally for service or maintenance purposes, in particular for the detection of a defect in a conductor 1 of an electrical circuit, for example of a device like a motor or a transformer. The electrical circuit can comprise several service points on the conductor 1, at which a first temperature sensor 2 is temporarily arranged and the temperature change induced in the conductor 1 by the overcurrent is measured. It is then very easy to locate a defect in the conductor 1. For maintenance purposes the apparatus is preferably constructed as a standalone apparatus, in particular as a handheld device.

List of Designations

1      conductor
10     conductor region
11     electrical insulation
12     conductive heating element
13     recess
2      first temperature sensor
3      calculation unit
4      heat insulation
5      second temperature sensor
A1     first cross-section
A2     second cross-section

**Claims**

1. Apparatus for the detection of an overcurrent in an electrical conductor (1), comprising a first temperature sensor (2), which is galvanically separated from the conductor (1), **characterized in that**

   the first temperature sensor (2) is aligned towards the conductor (1) to directly measure the temperature or temperature change induced in the conductor (1), and that
   the apparatus comprises an allocation unit (3) for allocating the measured temperature or temperature change in the conductor (1) to the overcurrent.

2. Apparatus according to claim 1, **characterized in that**

   the first temperature sensor (2) is an infrared sensor, in particular a pyroelectrical sensor, or a thermopile sensor.

3. Apparatus according to claim 1 or 2, **characterized in that**

   the apparatus comprises means for enhancing the thermal radiation emitted from the conductor (1) towards the first temperature sensor (2).

4. Apparatus according to claim 3, **characterized in that**

   the means for enhancing the thermal radiation towards the first temperature sensor (2) comprise a conductor region (10) with decreased cross-section, in particular a recess (13) in the conductor, and that
   the first temperature sensor (2) is aligned towards said conductor region (10).

5. Apparatus according to claim 3 or 4, **characterized in that**

   the means for enhancing the thermal radiation towards the first temperature sensor (2) comprise a conductor region (10) with a treated surface, in particular by a modified surface structure or a modified surface colouring, and that
   the first temperature sensor (2) is aligned towards said conductor region (10).

6. Apparatus according to any of the claims 3 to 5, **characterized in that**

   the means for enhancing the thermal radiation towards the first temperature sensor (2) comprise a convex shaped infrared lens arranged between the first temperature sensor (2) and the conductor (1).

7. Apparatus according to any of the claims 3 to 6, **characterized in that**

   the means for enhancing the thermal radiation towards the first temperature sensor (2) comprise a conductor region (10) with a conductive heating element (12), which conductive heating element (12) has an enhanced specific resistance, and that

the first temperature sensor (2) is aligned towards said conductor region (10).

8. Apparatus according to any of the preceding claims, **characterized in that**

the temperature coefficient of the specific resistance of the conductor (1) is constant in the temperature range of interest.

9. Apparatus according to any of the preceding claims, **characterized in that**

the conductor (1) and/or the first temperature sensor (2) are at least partially enclosed by a heat insulation (4).

10. Apparatus according to any of the preceding claims, **characterized in that**

the allocation unit (3) comprises means for the calculation of the overcurrent from the measured temperature or temperature change according to

$$I = \sqrt{\frac{\Delta T}{\Delta t} \frac{A^2 \gamma c}{\rho}},$$

with I being the calculated overcurrent, $\Delta T$ being a measured temperature change, $\Delta t$ being a time period, over which the temperature change is measured, A being a cross-section, $\gamma$ being a specific weight, c being a specific heat capacity and $\rho$ being a specific resistance of the conductor (1).

11. Apparatus according to any of the preceding claims, **characterized in that**

the apparatus comprises a power supply, which is capacitively or inductively coupled to the conductor (1) for the purpose of power feeding the apparatus.

12. Apparatus according to any of the preceding claims, **characterized in that**

the apparatus comprises a laser pointer, which can be fixed to the first temperature sensor (2) and which can be aligned to the same direction as the first temperature sensor (2).

13. Apparatus according to any of the preceding claims, **characterized in that**

the apparatus comprises a second temperature sensor (5) to measure an ambient temperature for calibration and/or correction purposes.

14. Apparatus according to any of the preceding claims, **characterized in that**

the apparatus is mounted in a device comprising at least one electrical conductor (1) or is designed as a standalone apparatus, in particular as a handheld apparatus for maintenance of a device comprising at least one electrical conductor (1).

15. Method for operating an apparatus for the detection of an overcurrent in an electrical conductor (1), in particular for operating the apparatus according to one of the preceding claims, the method comprising the following steps:

• a first temperature sensor (2), in particular an infrared sensor, which is galvanically separated from an electrical conductor (1), is aligned towards the conductor (1),
• a temperature or temperature change induced in the conductor (1) is directly measured with the first temperature sensor (2), and
• the measured temperature or temperature change is allocated in an allocation unit (3) to the overcurrent.

16. Method according to claim 15, **characterized in that**

the measured temperature or temperature change is allocated to an overcurrent by calculating the overcurrent according to

$$I = \sqrt{\frac{\Delta T}{\Delta t} \frac{A^2 \gamma c}{\rho}},$$

with I being the calculated overcurrent, $\Delta T$ being a measured temperature change, $\Delta t$ being a time period, over which the temperature change is measured, A being a cross-section, $\gamma$ being a specific weight, c being a thermal capacitance and $\rho$ being a specific resistance of the conductor (1).

17. Method according to claim 15 or 16, **characterized in that**

an ambient temperature is measured with a second temperature sensor (5) and that the ambient temperature is taken into account in the calculation of the overcurrent in the conductor (1).

**18.** Method according to any of the claims 15 to 17, **characterized in that**

when reaching a limit value, in particular a maximum allowed overcurrent, a maximum allowed overcurrent over a defined time period and/or a maximum allowed overcurrent change, a signal is generated.

**19.** Method according to of the claims 15 to 18, **characterized in that**

from the calculated overcurrent or overcurrent change a prospective remaining time is estimated until a limit value, in particular a maximum allowed overcurrent and/or a maximum allowed overcurrent over a defined time period, will be reached.

**20.** Method according to of the claims 15 to 19, **characterized in that**

the method is performed continuously during operation and/or occasionally during maintenance.

**21.** Primary electrical apparatus of a primary or secondary substation comprising an apparatus for the detection of an overcurrent in an electrical conductor (1) according to any of claims 1 to 14.

FIG. 1

FIG. 2

FIG. 3

FIG. 4

**European Patent Office**

**EUROPEAN SEARCH REPORT**

Application Number

EP 05 40 5563

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | PATENT ABSTRACTS OF JAPAN<br>vol. 1998, no. 03,<br>27 February 1998 (1998-02-27)<br>& JP 09 289731 A (MITSUBISHI ELECTRIC CORP), 4 November 1997 (1997-11-04)<br>* abstract * | 1,2,<br>8-11,<br>13-21 | H02H5/04 |
| X | PATENT ABSTRACTS OF JAPAN<br>vol. 006, no. 046 (P-107),<br>24 March 1982 (1982-03-24)<br>& JP 56 162019 A (HITACHI CABLE LTD;<br>others: 01), 12 December 1981 (1981-12-12)<br>* abstract * | 1,15 | |
| A | EP 0 869 598 A (KOEPPL, GEORG)<br>7 October 1998 (1998-10-07)<br>* column 1, line 47 - column 2, line 20 * | 3,4 | |
| A | YOUSSEF M ED - INSTITUTE OF ELECTRICAL AND ELECTRONICS ENGINEERS: "A new method for temperature measurement of overhead conductors"<br>IMTC 2001. PROCEEDINGS OF THE 18TH. IEEE INSTRUMENTATION AND MEASUREMENT TECHNOLOGY CONFERENCE. BUDAPEST, HUNGARY, MAY 21 - 23, 2001, IEEE INSTRUMENTATION AND MEASUREMENT TECHNOLOGY CONFERENCE. (IMTC):, NEW YORK, NY : IEEE, US,<br>vol. VOL. 1 OF 3. CONF. 18,<br>21 May 2001 (2001-05-21), pages 966-969,<br>XP010545905<br>ISBN: 0-7803-6646-8<br>* paragraph [0001] - paragraph [0011] * | 1,15 | |

**TECHNICAL FIELDS SEARCHED (IPC)**

H02H
G01R

The present search report has been drawn up for all claims

| Place of search | Date of completion of the search | Examiner |
|---|---|---|
| The Hague | 20 February 2006 | Colombo, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**
EP 05 40 5563

This annex lists the patent family members relating to the patent documents cited in the above-mentioned European search report.
The members are as contained in the European Patent Office EDP file on
The European Patent Office is in no way liable for these particulars which are merely given for the purpose of information.

20-02-2006

| Patent document cited in search report | | Publication date | Patent family member(s) | | Publication date |
|---|---|---|---|---|---|
| JP 09289731 | A | 04-11-1997 | JP | 3355920 B2 | 09-12-2002 |
| JP 56162019 | A | 12-12-1981 | JP | 1429694 C | 09-03-1988 |
| | | | JP | 62039887 B | 25-08-1987 |
| EP 0869598 | A | 07-10-1998 | NONE | | |

EPO FORM P0459

For more details about this annex : see Official Journal of the European Patent Office, No. 12/82

**EP 1 770 842 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4054934 A